# EUROPEAN PATENT SPECIFICATION

(11) **EP 0 366 831 B1**
(45) Date of publication and mention of the grant of the patent: **10.03.1993**
(21) Application number: 88118442.8
(22) Date of filing: 04.11.1988
(51) Int. Cl.: G01R 19/22, G01D 3/04

(54) **Temperature compensating circuit**
Temperaturkompensationsschaltung
Circuit compensateur de température

(43) Date of publication of application: 09.05.1990
(73) Proprietor: HORIBA, LTD., Minami-ku Kyoto (JP)
(72) Inventor: Asano, Ichiro, Kouka-gun Shiga Prefecture (JP); Kihara, Nobutaka, Soraku-gun Kyoto (JP); Inoue, Satoshi, Toyonaka-city Osaka (JP)
(74) Representative: TER MEER STEINMEISTER & PARTNER GbR

(56) References cited:
- EP-A- 0 141 080
- DE-A- 2 652 314
- GB-A- 2 010 487

## Description

The present invention relates to a temperature compensating circuit for subjecting a detected signal (measured signal voltage) by various kinds of analyzers, such as a gas analyzer, to a temperature compensating treatment.

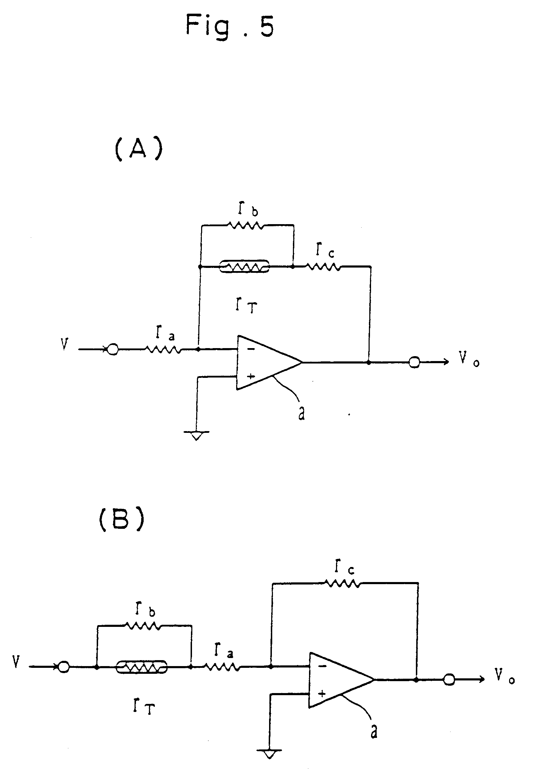

For example, as shown in Fig. 5(A) and (B), a known oxygen meter is adapted to have a plurality of displaying functions, such as the display of dissolved oxygen in a partial pressure ratio and the display of a dissolved oxygen (DO) in a concentration, in addition to the display of the detected temperature itself. It is, however, necessary to subject the measured signal to individual temperature compensating treatments for the respective displays. Some other gas analyzers are able to analyze concentrations of a plurality of kinds of gases also. In such cases it its also necessary to subject the detected signals of concentrations of the respective gases to the individual temperature compensating treatment.

The conventional temperature compensating circuit is adapted to provide a temperature sensitive (resistance) element r_{T} in a feedback circuit portion of an operational amplifier a, in which a measured signal voltage V is fed, or in an input circuit portion of said operational amplifier a (any one of them is selected depending upon the polarity of the temperature characteristics of the measured signal voltage) to change the gain of the operational amplifier a in response to the temperature. The result is a temperature compensated measured signal voltageV₀.

However, the above described conventional temperature compensating circuit has shown the following various disadvantages:
(i) Since once set of the operational amplifier a and the temperature sensitive (resistance) element r_{T} is necessary for each measured signal voltage V, the temperature compensating circuit for carrying out the temperature compensation for a plurality of measured signal voltages, respectively, is constructed in the above described manner, the number of parts for such circuit is remarkably increased. Furtheron, not only the costs of the production are increased but also the construction is complicated and large-sized.
(ii) Since complicate calculations are necessary for determining the characteristics of the temperature sensitive (resistance) element r_{T} and the resistance values of other resistors rₐ, r_{b}, r_{c} depending upon the temperature characteristics of the measured signal voltage V, in particular when the temperature compensating circuit for carrying out the temperature compensation for a plurality of measured signal voltages, respectively, is constructed in the above described manner the design of this circuit is very difficult.
(iii) Since the circuit constructions are quite different in structure, as shown in Fig. 5(A), (B), and must be selectively adopted in response to the polarity of the temperature characteristics of the measured signal voltage V, if the temperature compensating circuit is constructed for compensating a plurality of measured signal voltages V which are different in the polarity of the temperature characteristics, the design of this circuit is still more difficult.
(iv) Since the operational amplifier a which is an indispensable constituent element of the circuit, itself can produce errors (temperature drift and the like) due to the influence of the surrounding temperature, the temperature compensation has not the desired accuracy.

Therefore, a temperature compensating circuit has been developed capable of carrying out the compensation for a plurality of measured signal voltages, respectively, by means of only one temperature sensitive element and by using a detected temperature signal obtained by said one temperature sensitive element. This temperature compensating circuit has been proposed in Japanese Patent Application No. Sho 57-44869 (Japanese Patent Laid-Open No. Sho 58-160859), Japanese Utility Model Application No. Sho 60-146072 (Japanese Utility Model Laid-Open No. Sho 62-53356) and the like.

However, this improved temperature compensating circuit still has the following problems:
In the case where the temperature compensating circuit is constructed for carrying out the temperature compensation for a plurality of measured signal voltages, respectively, and because only one temperature sensitive (resistance) element is sufficient but one comparatively expensive operational amplifier is necessary for a plurality of measured signal voltages, respectively, not only the reduction of the costs of the production and the simplification and miniaturization in construction are not sufficiently realized but also the disadvantages (ii), (iii) incidental to the temperature compensating circuit having the above described conventional construction are still not eliminated.

Thus, it is an object of the present invention to develop and provide a temperature compensating circuit capable of remarkably reducing the number of constituent part, simplifying and miniaturizing inexpensively the construction, remarkably lowering the difficulties for the design corresponding to the temperature characteristics of the measured signal voltage and carrying out a temperature compensation with a remarkably higher accuracy.

In order to achieve the above described object, the present invention provides a temperature compensating circuit comprising:
- one temperature-pulse width conversion circuit portion adapted to generate a pulse width signal, by which a duty ratio which is a time ratio of a high signal period width to a repetition period of pulses is changed in response to a temperature detected by a temperature sensitive element, and
- at least one temperature compensating circuit portion adapted to apply a temperature compensating treatment to a measured signal voltage derived from an input terminal on the basis of said duty ratio and then supplying the temperature compensated measured signal voltage to an output terminal, characterized in that
- said temperature compensating circuit portion comprises voltage-dividing means for dividing the measured signal voltage which is supplied through said input terminal, into a large signal voltage and a small signal voltage and
- change-over means for alternately putting out said large and small signal voltages supplied from the voltage-dividing means to said output terminal in response to a HIGH/LOW change of the pulse width signal supplied from said temperature-pulse width conversion circuit portion.

Such the characteristic construction exhibits the following operation:
The temperature compensating circuit according to the above described present invention, as still more obvious also from the description of the preferred embodiments which will be mentioned lated, exhibits various kinds of advantages.
(I) Even in the case where the temperature compensating circuit is adapted to carry out the temperature compensation for a plurality of measured signal voltagesV_{NI} (N = 1,2---), respectively, this circuit is simplified and improved because each of the plurality of temperature compensating circuit portions Y_{N}(N = 1,2---) provided one by one which the respective measured signal voltages V_{NI} is adapted to use the pulse width signal Vₚ which is formed by the only one temperature-pulse width conversion circuit portion X, and as described as follows, the respective temperature compensating circuit portions Y_{N} are simple in construction to such an extend that the operational amplifier is not required. The use of only one set of the operation amplifier and the temperature sensitive element R_{T} which are comparatively expensive in the temperature-pulse width conversion circuit portion X is sufficient for the whole temperature compensating circuit. Accordingly, the remarkable reduction of the number of parts and thus the simplification and miniturization as well as the reduction of the costs of the production can be achieved.
(II) in the respective temperature compensating circuit portions Y_{N} the measured signal voltage V_{NI} is divided into the large and the small signal voltage V_{NB}, V_{NS} (V_{NB}>V_{NS}) by means of the voltage dividing means C_{N}, which can be very simply and inexpensively constructed by using merely a plurality (at least two) resistors connected to each other basically in series. Then said large and small signal voltages V_{NB}, V_{NS} are alternatively given out through the output terminal O_{N} in response to the HIGH/LOW change of the pulse width signal Vₚ supplied from said temperature-pulse width conversion circuit portion X by means of the change-over means D_{N}. This change-over means D_{N} can be constructed by using a remarkable simple and inexpensive switching element likewise. In this way a weighted average of said large and small signal voltages V_{NB}, V_{NS} which are chosen in response to the duty ratio D (T) of said pulse width signal Vₚ is given out as the temperature compensated measured signal voltage V_{NO} from the output terminal O_{N}. Therefore with the present invention the respective temperature compensating circuit portions Y_{N} do not require the use of not only the operational amplifier, which cannot but being expensive and making the circuit structure remarkably complicate as in the case of the conventional temperature compensating circuits, but also the temperature sensitive element, that is, the respective temperature compensating circuit portions Y_{N} can be very simply and inexpensively constructed. Also the calculations (design) for determining the resistance values of the resistors used depending upon the temperature characteristics of the measured signal voltages V_{NI} supplied to the respective temperature compensating circuit portions Y_{N} can carried out very simple.
(III) Even in the case where the temperature characteristics of the measured signal voltages V_{NI} are different in polarity, the construction of the circuit as a whole does not require any remarkable change. Its very simple change in design is sufficient, for example change-over means with different change-over characteristics are used as the change-over means D_{N}, for changing over alternately in response to the HIGH/LOW change of the pulse width signal Vₚ supplied from the temperature-pulse width conversion circuit portion X. Or an inverting element is provided on the way of a signal line extending from the temperature-pulse width conversion circuit portionX to the cange-over means D_{N}.
(IV) Since the respective temperature compensating circuit portions Y_{N} can be constructed without using the operational amplifier, which could produce the errors (temperature drift and the like) due to the influence of the surrounding temperature, as above described, the temperature compensation can be remarkably improved in accuracy in comparison with the conventional circuit.

The preferred embodiments of the temperature compensating circuit according to the present invention are below described with reference to the drawings. In the drawings:

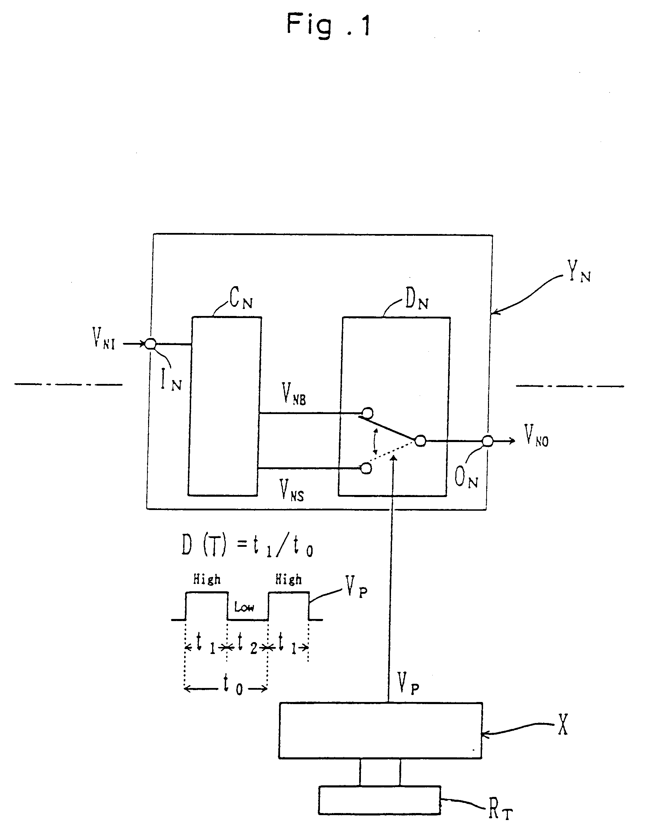

- Fig. 1: is a basic circuit diagram showing a temperature compensating circuit according to the present invention;
- Fig. 2: is a whole circuit diagram;
- Fig. 3: is a graph showing one set example of characteristics (pulse signal) of principal parts;
- Fig. 4(A), (B): is a circuit diagram showing modifications of the principal parts; and
- Fig. 5(A), (B): is a diagram showing the conventional temperature compensating circuits used for describing the technical background of the present invention and the problems of the prior art.

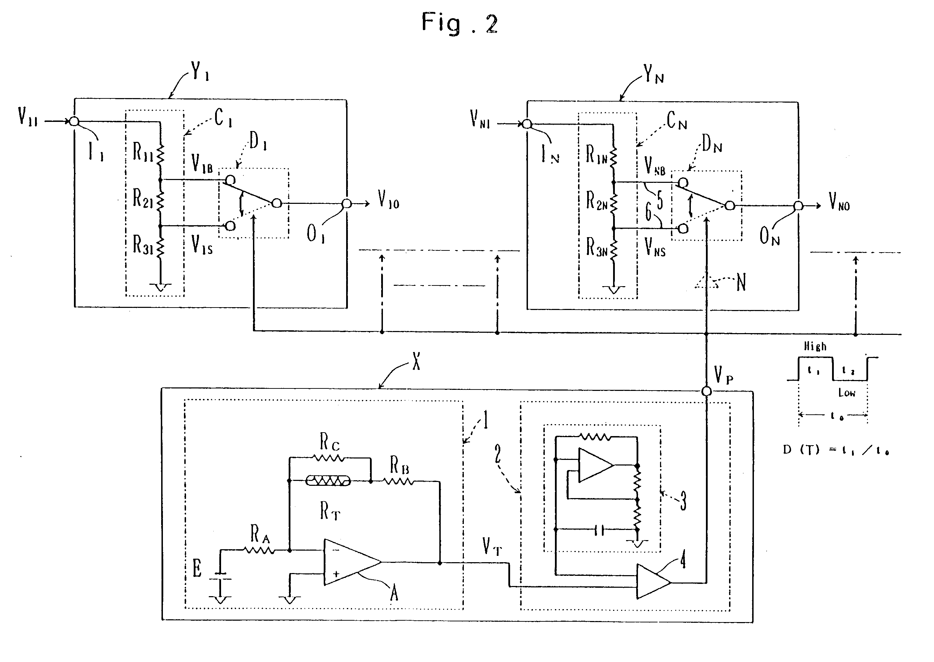

Referring to Fig. 2 showing the whole construction of the circuit, X designateds one temperature-pulse width conversion circuit portion adapted to generate the pulse width signal Vₚ (this will be mentioned in detail) of the duty ratio D(T) in response to the temperature detected by the temperature sensitive element R_{T}, Y₁,..., Y_{N} designate temperature compensating circuit portions connected to said temperature-pulse width conversion circuit protion X and adapted to apply the temperature compensating treatment to the measured signal voltage V_{NI} derived from the input terminal I_{N} and then to give out the measured signal voltage V_{ND} which has been compensated through the output terminal O_{N}, respectively.

Said temperature-pulse width conversion circuit portion X comprises a temperature measuring portion 1 producing a voltage V_{T} corresponding to the temperature and a voltage-pulse width converter 2 putting out the pulse width signal Vₚ. This pulse width signal Vₚ changes the ratio D(T) (=t₁/t₀: the time ratio of the HIGH period width t₁ to the repetition periods of pulses t₀) in proportion to the voltage V_{T} corresponding to the temperature supplied from the temperature measuring circuit portion 1. Said temperature measuring circuit portion 1 comprises a feedback resistor R_{B}, the temperature sensitive (resistance) element R_{T}, such as a thermistor, a resistor R_{C} for improving the linearity and the like. Said resistors are provided in the feedback circuit portion of the operational amplifier A. The non-inverting input terminal of this operational amplifier A is grounded and its inverting input terminal is connected to a reference power source E and an input resistor R_{A}. The voltage-pulse width converter 2 has the known construction comprising a triangular wave generator 3 and a comparator 4 to which a triangular wave-shaped pulse from the triangular wave generator 3 and the voltage V_{T} from said temperature measuring circuit portion 1 are supplied.

The temperature compensating circuit portion Y_{N}, (all temperature compensating circuit portions have the same construction, so that here merely the N-th temperature compensating circuit portion Y_{N} is described) comprises a first resistor R_{1N}, a second resistor R_{2N} and a third resistor R_{3N} connected in series so that the measured signal voltage V_{N1} derived from the input terminal I_{N} may be divided into the large signal voltage V_{NB} and the small signal voltage V_{ND} (V_{NB}> V_{NS}) and given out. This temperature compensating circuit portion Y_{N} is provided with the voltage-dividing means C_{N} comprising a signal output line 5 and a signal output line 6 extending from between the first resistor R_{1N} and the second resistor R_{2N} and between the second resistor R_{2N} and the third resistor R_{3N}, respectively. The changeover means D_{N} is comprising a switching element, such as an analog switch, so that the large and small signal voltages V_{NB}, V_{NS} are supplied through the signal output lines 5 and 6 from the voltage-dividing means C_{N} and can alternately fed to said output terminal O_{N} in response to the HIGH/LOW change of the pulse width signal Vₚ. The pulse width signal Vₚ is supplied from said temperature-pulse width conversion circuit portionX. In short, the weighted average value of said large and small signal voltages V_{NB}, V_{NS} which are changed in response to the duty ratio D(T) of the pulse width signal Vₚ is supplied to said output terminal O_{N} as the measured signal voltage V_{NO} which has been subjected to the temperature compensation. In addition, the change-over characteristics of said change-over means D_{N} may be suitably determined depending upon the polarity of the measured signal voltage V_{NI}. But in the case where the change-over means D_{N} with the same change-over characteristics is used independent of the polarity of the measured signal voltage V_{NI}, an inverting element N may be provided in the signal line extending from the temperature-pulse width conversion circuit portion X to the change-over means D_{N} if necessary.

In the temperature compensating circuit having the above described construction said change-over means D_{N} is set so that the large signal voltage V_{NB} is connected to the output terminal O_{N} when the pulse width signal Vₚ is HIGH. While the small signal voltage V_{NS} is connected to the output terminal O_{N} when the pulse width signal Vₚ is LOW. The weighted average value V_{NO} of said large and small signal voltages V_{NB}, V_{NS} supplied to the output terminal O_{N} is expressed by the following equation 1:

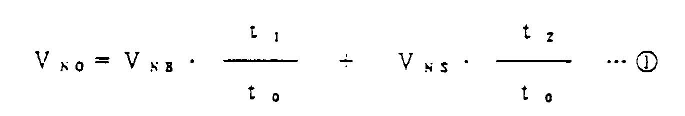

With

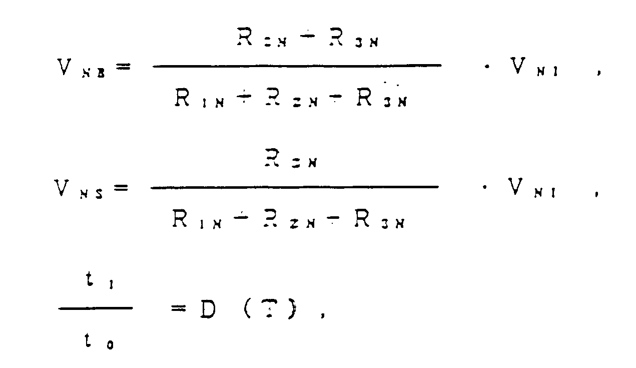

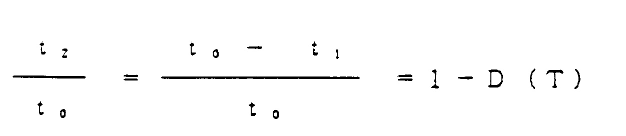

So that the following equation 2 is derived from the above described equation 1:

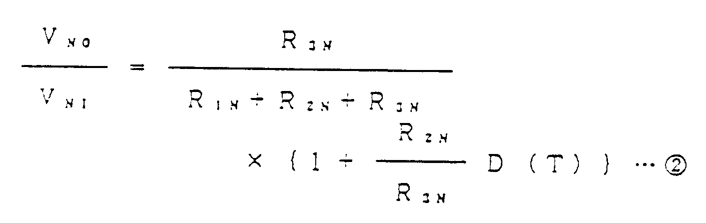

A temperature coefficient V_{N0}/V_{NI} of the temperature compensating circuit portion Y_{N} is dependent upon said duty ratio D(T) of the pulse width signal Vₚ (in short, the temperature characteristics of the temperature-pulse width conversion circuit portion X), upon R_{3N}/(R_{1N} + R_{2N} + R_{3N}) and upon R_{2N}/R_{3N}.

On the other hand, in the case where said change-over means D_{N} is set so as to have the change-over characteristics opposite to those in the above described case, the weighted average value V_{NO} of said large and small signal voltages V_{NB}, V_{NS} fed to the output erminal O_{N} is expressed by the following equation 1′:

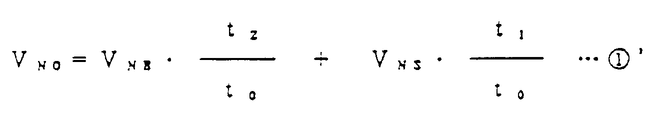

The temperature coefficient V_{N0}/V_{NI} of the temperature compensating circuit portion Y_{N} is expressed by the following equation 3:

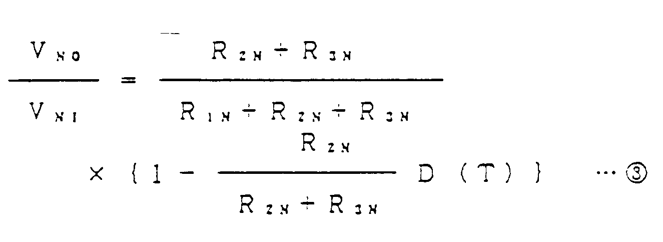

The temperature coefficient V_{N0}/V_{NI} of the temperature compensating circuit portion Y_{N} depends on said duty ratio D(T) of the pulse width signal Vₚ, on (R_{2N} + R_{3N})/(R_{1N} + R_{2N} + R_{3N}) and on R_{2N}/(R_{2N} + R_{3N}).

Accordingly, in every case, there is a clear guide by the above described equation 2 or 3 and the first resistor R_{1N}, the second resistor R_{2N} and the third resistor R_{3N} in said voltage-dividing means C_{N} are simply connected in series, so that the design calculations for suitably determining the respective resistance values of the first resistor R_{1N}, the second resistor R_{2N} and the third resistor R_{3N} in response to the temperature characteristics of the measured signal voltage V_{NI} can be very easily conducted.

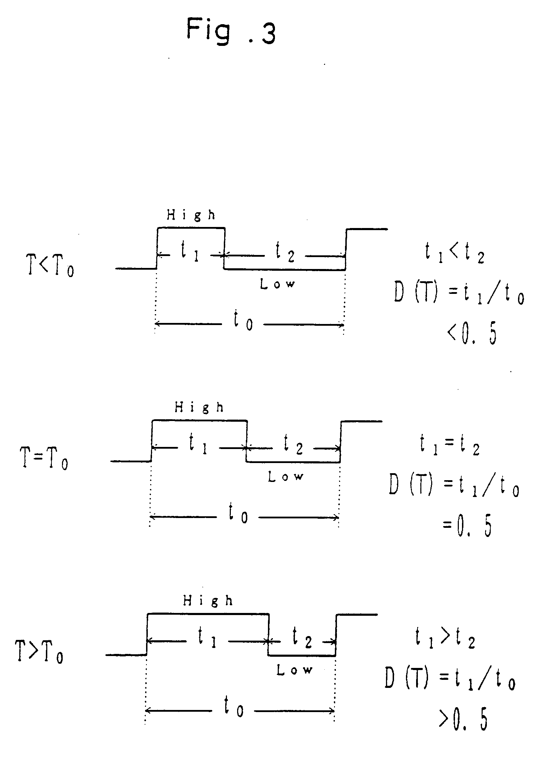

In addition, if the resistance value of said first resistor R_{1N} is equal to that of said third resistor R_{3N} and said second resistor R_{2N} is a variable resistor and furthermore said temperature-pulse width conversion circuit portion X is set so that the duty ratio D (T) of the pulse width signal Vₚ given out therefrom may amount to 0.5 when the temperature T is equal to the reference temperature T₀ (for example 20°C), as shown in Fig. 3, the temperature coefficient V_{N0}/V_{NI} of the temperature compensating circuit portion Y_{N} is expressed as follows:
If 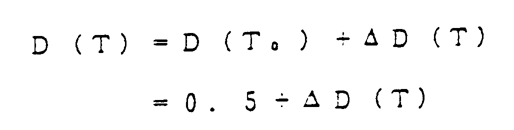
is put in said equation 3, the following equation 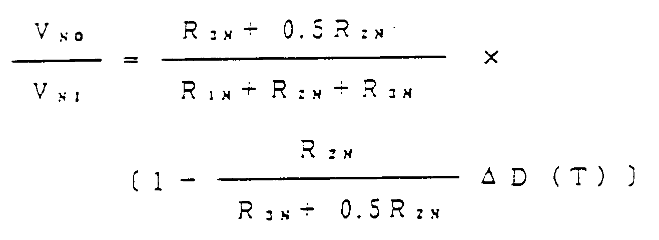
holds good, so that, now if

$\text{Δ D(T) = D(T) - 0.5}$
${\text{and R}}_{\text{1N}} {\text{= R}}_{\text{3N}}$

are put in the above described resulting equation, the following equation 4 is obtained:

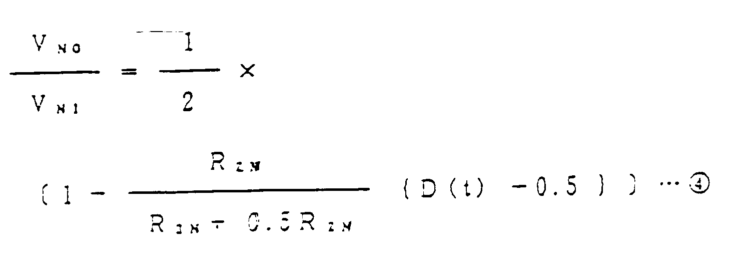

It is found from this equation 4 that since D(t) = 0.5 holds good when the temperature T is equal to the reference temperature T₀, the V_{N0}/V_{N1} constantly amounts to 1/2 independent of the resistance value of the second resistor R_{2N}. Whereby the output V_{N0} from the temperature compensating circuit portion Y_{N} is unchanged even though the variable resistor forming the second resistor R_{2N} is adjusted at any value. Accordingly, in this case, a great advantage occurs in that the temperature coefficient of the temperature compensating circuit portion Y_{N} can be very easily adjusted in response to the temperature characteristics of the individual measured signal voltage V_{NI} by merely carrying out such a remarkably simple operation. This operation is that said variable resistor (the second resistor R_{2N}) is adjusted so that the output V_{N0} of the temperature compensating circuit portion Y_{N} at a temperature T (for example 40°C) different from the reference temperature T₀ may have the same value as that at said reference temperature T₀.

In addition, in the case where such the secondary advantage is not required, said first resistor R_{1N} may be omitted. It is rather desirable to omit the first resistor R_{1N} from a viewpoint of still more simplifying the design calculations for determining the needed resistance value.

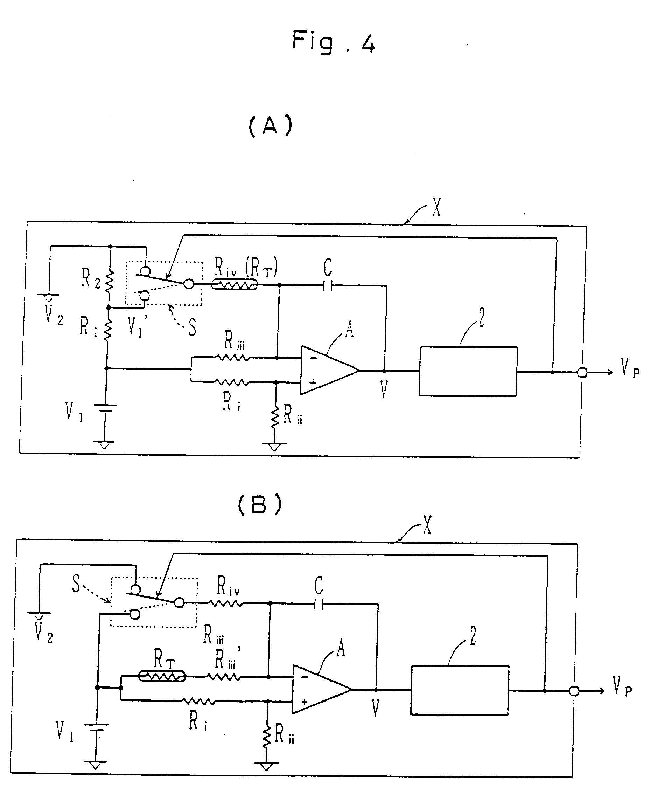

Fig. 4(A), (B) show the modifications of said temperature-pulse width conversion circuit portion X.

In the above described Fig. 2 the temperature-pulse width conversion circuit portion X is having the so-called open loop construction, in which the voltage V_{T} corresponding to the temperature is generated by means of the temperature measuring circuit portion 1. The generated voltage V_{T} is supplied to the voltage-pulse width converter 2 to obtain the pulse width signal Vₚ having the duty ratio D(T) corresponding to the temperature T, as shown. The temperature-pulse width conversion circuit portion X according to these modifications has the following closed loop construction.

The temperature-pulse width conversion circuit portion X shown in Fig. 4(A) comprises an integration circuit dividing a first reference voltage V₁ by means of a first resistor Rᵢ and a second resistor Rᵢᵢ. The divided voltages are supplied in a non-inverting input terminal of an operational amplifier A and through a third resistor Rᵢᵢᵢ to its inverting input terminal. The output from the operational amplifier A is fed back to its inverting input terminal through a capacitor C. This circuit is further provided with a voltage-pulse width converter 2 having the same construction as the above described one and forming a pulse width signal Vₚ having a duty ratio D(T) corresponding to an output voltage V from the integration circuit and with a switch-over means S. This switch-over means S is a switching element, such as an analog switch, carrying out the switch-over operation by the pulse width signal Vₚ. The pulse width signal Vₚ is supplied from the voltage-pulse width converter 2 to the control input of said switch-over means S. Therefore the voltage V_{1'} obtained by dividing said first reference voltage V₁ by means of the voltage dividing resistors R₁, R₂ and a second reference voltage V₂ (in this preferred embodiment an earth voltage =0) is supplied to the inverting input terminal of the operational amplifier A intermittently through a fourth resistor Rᵢᵥ. One of said first to fourth resistors Rᵢ to Rᵢᵥ (in this preferred embodiment the fourth resistor Rᵢᵥ) is formed of a temperature sensitive (resistance) element R_{T}, such as a thermistor. In addition, in this preferred embodiment said switch-over means S is set so as to have switching-over characteristics that the partial voltage V_{1'} of said first reference voltage V₁ is HIGH and is connected to the temperature sensitive (resistance) element R_{T} when the pulse width signal voltage Vₚ is fed back from the voltage-pulse width converter 2. While the second reference voltage V₂ (earth voltage = 0) is connected to the temperature sensitive (resistance) element R_{T} when the pulse width signal Vₚ is LOW.

The temperature-pulse width conversion circuit portion X having the abvove described construction operates as follows:

If the temperature T is risen, whereby the resistance value of the temperature sensitive (resistance) element R_{T} is increased, an electric current supplied to the inverting input terminal of the operational amplifier A is reduced. Thereby an output voltage V of the operational amplifier A is increased in the positive direction, so that a HIGH period width t₁ of the pulse width signal Vₚ derived from the voltage-pulse width converter 2 and fed back is lengthened. An average voltage supplied to the temperature sensitive (resistance) element R_{T} from the switchover means S is thereby increased since the supply period of the partial voltage V_{1'} of the first reference voltage is lengthened while the supply period of the second reference voltage V₂ (earth voltage = 0) is shortened. Accordingly, the electric current supplied to the inverting input terminal of the operational amplifier A is increased, whereby the output voltage V shows a tendency to be reduced. As a result, the electric current supplied to the inverting input terminal of the operational amplifier A amounts to 0 to establish a stabilized condition. Therefore the output voltage V from the operational amplifier A and the pulse width signal Vₚ given out from the voltage-pulse width coverter 2 amount to constant values. Further, in the case where the temperature T is lowered, whereby the resistance value of the temperature sensitive (resistance) element R_{T} is reduced, the stabilized condition is established through an operation opposite to the above described.

Under such a stabilized condition, 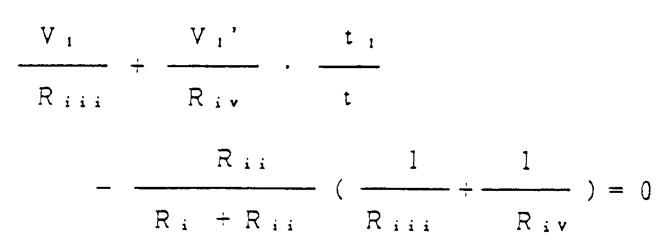
holds good, so that the following equation 5 holds good: 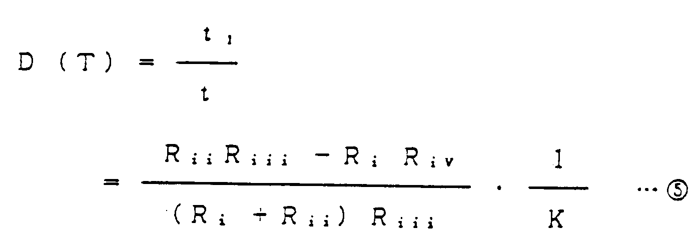
[wherein K=V_{1'}/V₁ (partial voltage ratio: constant)].

Since the resistance values of Rᵢ, Rᵢᵢ and Rᵢᵢᵢ and the partial voltage ratio K (=V_{1'}/V₁) are all constant in this equation 5, it is clear that the duty ratio D(T) of the pulse width signal Vₚ supplied from the voltage-pulse width converter 2 is proportional to Rᵢᵥ. In short, the duty ratio D(T) is proportional to the resistance value of the temperature sensitive (resistance) element R_{T}, and thus to the temperature T. In addition, as found from this equation 5, with the temperature-pulse width conversion circuit portion X having the above described construction, this duty ratio D(T) of the pulse width signal Vₚ is not influenced by not only the first reference voltage V₁ itself (singly) but also the characteristics of the voltage-pulse width converter 2 itself. Therefore, even though the first reference voltage V₁ is fluctuated or the inexpensive voltage-pulse width converter 2 inferior in linearity and stability is used, the sufficient high accurate temperature-pulse width conversion function can be secured by the compensating operation of the operational amplifier A due to the above described feedback construction.

Fig. 4(B) shows the temperature-pulse width conversion circuit portion X shown in the above described Fig. 4(A) in which the voltage dividing resistors R₁, R₂ are omitted. The first reference voltage V₁ itself is supplied to the switch-over means S. The third resistor Rᵢᵢᵢ being composed of the temperature sensitive (resistance) element R_{T} and a linearity improving resistor R_{iii'}. Other constructions and operations are basically the same as those shown in the above described Fig. 4(A), so that the description of them is omitted by marking the parts having the same functions with the same reference numerals.

As obvious from the above description, the temperature compensating circuit according to the present invention exhibits various kinds of advantages. Even in the case where the temperature compensating circuit is adapted to carry out the temperature compensation for a plurality of measured signal voltages, respectively, this circuit is simplified and improved because each of the plurality of temperature compensating circuit portions provided one by one with the respective measured signal voltages is adapted to use the pulse width signal which is formed by the only one temperature-pulse width conversion circuit portion, and the respective temperature compensating circuit portions are remarkably simple in construction to such an extent that the provision of the operational amplifier is not required. The use of only one set of the operational amplifier and the temperature sensitive element which are comparatively expensive in the temperature-pulse width conversion portion is sufficient for the whole temperature compensating circuit. Therefore, the remarkable reduction of the number of parts and thus the simplification and miniaturization as well as the reduction of the costs of the production can be achieved. The design of the temperature compensating circuit portion depending upon the temperature characteristics of the respective measured signal voltages and the polarity thereof can be very simply conducted. Furthermore, because these respective temperature compensating circuits do not require an operational amplifier which could produce errors, i.e. temperature drift and the like, due to the influence of the surrounding temperature, the accuracy of the temperature compensation can be remarkably improved in comparison with that in the conventional temperature compensating circuits.

R_{T} - - - Temperature sensitive element; T - - - Temperature; D(T) - - -Duty ratio; t₀ - - - Repetition period of pulses; t₁ - - - HIGH period width; t₂ - - - LOW period width; Vₚ - - - Pulse width signal; X - - - Temperature-pulse width conversion circuit portion ; I_{N} - - - Input terminal; V_{NI} - -- - Measured signal voltage; V_{N0} - - - (Output) measured signal voltage which has been subjected to the temperature compensating treatment; O_{N} - - - Output terminal; Y_{N} - - - Temperature compensating circuit portion; V_{NB} - - - Large voltage signal; V_{S} - - - Small voltage signal; C_{N} - - - Voltage dividing means; D_{N} - - - Change-over means.

## Claims

1. A temperature compensating circuit comprising:
- one temperature-pulse width conversion circuit portion (X) adapted to generate a pulse width signal (Vₚ), by which a duty ratio (D(T)) which is a time ratio of a high signal period width (t₁) to a repetition period of pulses (t₀) is changed in response to a temperature detected by a temperature sensitive element (R_{T}), and
- at least one temperature compensating circuit portion (Y_{N}) adapted to apply a temperature compensating treatment to a measured signal voltage (V_{NI}) derived from an input terminal (I_{N}) on the basis of said duty ratio (D(T)) and then supplying the temperature compensated measured signal voltage (V_{N0}) to an output terminal (O_{N}), **characterized in** that
- said temperature compensating circuit portion (Y_{N}) comprises voltage-dividing means (C_{N}) for dividing the measured signal voltage (V_{NI}) which is supplied through said input terminal (I_{N}), into a large signal voltage (V_{NB}) and a small signal voltage (V_{NS}) and
- change-over means (D_{N}) for alternately putting out said large and small signal voltages (V_{NB}, V_{NS}) supplied from the voltage-dividing means (C_{N}) to said output terminal (O_{N}) in response to a HIGH/LOW change of the pulse width signal (Vₚ) supplied from said temperature-pulse width conversion circuit portion (X).

2. A temperature compensating circuit according to claim 1, **characterized in** that said voltage dividing means (CN) is comprising at least two resistors (R_{2N}, R_{3N}...) connected in series and that one of said at least two resistors (R_{2N}, R_{3N}...) is a variable resistor.

3. A temperature compensating circuit according to claim 2, **characterized in** that said voltage dividing means (C_{N}) is comprising three resistors (R_{1N}, R_{2N}, R_{3N}) connected in series, whereby the taps for the divided voltages are arranged between said first and second resistor (R_{1N}, R_{2N}) and between said second and third resistors (R_{2N}, R_{3N}), respectively.

4. A temperature compensating circuit according to one of the claims 1 to 3, **characterized in** that the temperature-pulse width conversion circuit portion (X) is an open loop control circuit.

5. A temperature compensating circuit according to one of the claims 1 to 3, **characterized in** that the temperature-pulse width conversion circuit portion (X) is a closed loop control circuit.

6. A temperature compensating circuit according to one of the claims 1 to 3 **characterized in** that the temperature-pulse width conversion circuit portion (X) comprises:
- an integration circuit with an operational amplifier (A), a capacitor (C) inserted between the output terminal and the inverting input terminal of said operational amplifier (A), with voltage dividing means having a first resistor (Rᵢ) and a second resistor (Rᵢᵢ), said operational amplifier (A) is receiving the first reference voltage (V₁) via its non-inverting input terminal connected with said first and second resistors (Rᵢ, Rᵢᵢ) and via its inverting input terminal connected with said first reference voltage (V₁) through a third resistor (Rᵢᵢᵢ),
- two resistors (R₁, R₂) for dividing said first reference voltage (V₁) and a second reference voltage (V₂),
- switch-over means (S) connected with said two resistors (R₁, R₂) and with said inverting input terminal through a fourth resistor (Rᵢᵥ), and
- a voltage-pulse width converter (2) coupled with the output terminal of said operational amplifier (A) the output terminal of which is connected to a control input of said switch-over means (S).

7. A temperature compensating circuit according to claim 6, **characterized in** that one of said four resistors (Rᵢ, Rᵢᵢ, Rᵢᵢᵢ, Rᵢᵥ) is a temperature sensitive element (R_{T}).

8. A temperature compensating circuit according to one of the claims 1 to 3, **characterized in** that the temperature-pulse width conversion circuit portion (X) comprises:
- an integration circuit with an operational amplifier (A), a capacitor (C) inserted between the output terminal and the inverting input terminal of said operational amplifier (A), with voltage dividing means having a first resistor (Rᵢ) and a second resistor (Rᵢᵢ), said operational amplifier (A) is receiving a first reference voltage (V₁) via its non-inverting input terminal connected with said first and second resistors (Rᵢ, Rᵢᵢ) and via its inverting input terminal connected with said first reference voltage (V₁) through a third resistor (Rᵢᵢᵢ) and a temperature sensitive element (R_{T}) connected in series,
- switch-over means (S) connected with said first and second reference voltages (V₁, V₂)and with said inverting input terminal through a fourth resistor (Rᵢᵥ), and
- a voltage-pulse width converter (2) coupled with the output terminal of said operational amplifier (A) the output terminal of which is connected to a control input of said switch-over means (S).

## Patentansprüche

1. Temperaturkompensationsschaltung mit:
- einem Temperaturimpulsbreiten-Umwandlungsschaltungsabschnitt (X), der so ausgebildet ist, daß er ein Pulsbreitensignal (Vₚ) bildet, durch das ein Tastverhältnis (D(T)), das das zeitliche Verhältnis einer Periodendauer (T₁) eines Signals mit hohem Pegel zur Wiederholperiode von Impulsen (t₀) ist, abhängig von der von einem temperaturempfindlichen Element (R_{T}) erfaßten Temperatur verändert wird; und
- mindestens einem Temperaturkompensationsschaltungsabschnitt (Y_{N}), der so ausgebildet ist, daß er eine von einem Eingangsanschluß (I_{N}) zugeführte Meßsignalspannung (V_{NI}) einer Temperaturkompensationsbehandlung auf Grundlage des genannten Tastverhältnisses (D(T)) unterzieht und dann die temperaturkompensierte Meßsignalspannung (V_{N0}) einem Ausgangsanschluß (0_{N}) zuführt; **dadurch gekennzeichnet,** daß
- der Temperaturkompensationsschaltungsabschnitt (Y_{N}) eine Spannungsteilereinrichtung (C_{N}) zum Unterteilen der über den Eingangsanschluß (I_{N}) zugeführten Meßsignalspannung (V_{NI}) in ein Signal hoher Spannung (V_{NB}) und ein Signal niedriger Spannung (V_{NS}) und
- eine Umschalteinrichtung (D_{N}) aufweist, zum abwechselnden Ausgeben der von der Spannungsteilereinrichtung (C_{N}) zugeführten Signale großer und kleiner Spannung (V_{NB}, V_{NS}) an den Ausgangsanschluß (0_{N}), auf einen HOCH/NIEDRIG-Wechsel des Impulsbreitensignals (Vₚ) hin, wie es vom Temperaturimpulsbreiten-Umwandlungsschaltungsabschnitt (X) zugeführt wird.

2. Temperaturkompensationsschaltung nach Anspruch 1, **dadurch gekennzeichnet,** daß die Spannungsteilereinrichtung (C_{N}) mindestens zwei in Reihe geschaltete Widerstände (R_{2N}, R_{3N}, ...) aufweist und daß einer der mindestens zwei Widerstände (R_{2N}, R_{3N}, ...) ein variabler Widerstand ist.

3. Temperaturkompensationsschaltung nach Anspruch 2, **dadurch gekennzeichnet,** daß die Spannungsteilereinrichtung (C_{N}) drei in Reihe geschaltete Widerstände (R_{1N}, R_{2N}, R_{3N}) aufweist, wobei die Abgriffe für die Teilspannungen zwischen dem ersten und dem zweiten Widerstand (R_{1N}, R_{2N}) bzw. zwischen dem zweiten und dritten Widerstand (R_{2N}, R_{3N}) angeordnet sind.

4. Temperaturkompensationsschaltung nach einem der Ansprüche 1 bis 3, **dadurch gekennzeichnet,** daß der Temperaturimpulsbreiten-Umwandlungsschaltungsabschnitt (X) eine Schaltung mit offener Steuerschleife ist.

5. Temperaturkompensationsschaltung nach einem der Ansprüche 1 bis 3, **dadurch gekennzeichnet,** daß der Temperaturimpulsbreiten-Umwandlungssteuerabschnitt (X) eine Regelschleifenschaltung ist.

6. Temperaturkompensationsschaltung nach einem der Ansprüche 1 bis 3, **dadurch gekennzeichnet,** daß der Temperaturimpulsbreiten-Umwandlungsschaltungsabschnitt (X) folgendes aufweist:
- eine Integrierschaltung mit einem Operationsverstärker (A), einem zwischen den Ausgangsanschluß und den invertierenden Eingangsanschluß des Operationsverstärkers (A) eingefügten Kondensator (C), mit einer Spannungsteilereinrichtung mit einem ersten Widerstand (Rᵢ) und einem zweiten Widerstand (Rᵢᵢ), wobei der Operationsverstärker (A) die erste Bezugsspannung (V₁) über seinen mit dem ersten und dem zweiten Widerstand (Rᵢ, Rᵢᵢ) verbundenen nicht invertierenden Eingangsanschluß und über seinen mit der ersten Bezugsspannung (V₁) über einen dritten Widerstand (Rᵢᵢᵢ) verbundenen invertierenden Eingangsanschluß erhält;
- zwei Widerstände (R₁, R₂) zum Aufteilen der ersten Bezugsspannung (V₁) und einer zweiten Bezugsspannung (V₂);
- eine mit den zwei Widerständen (R₁, R₂) und mit dem invertierenden Eingangsanschluß über einen vierten Widerstand (Rᵢᵥ) verbundene Umschalteinrichtung (S); und
- einen Spannungsimpulsbreitenwandler (2), der mit dem Ausgangsanschluß des Operationsverstärkers (A) verbunden ist, dessen Ausgangsanschluß mit einem Steuereingang der Umschalteinrichtung (S) verbunden ist.

7. Temperaturkompensationsschaltung nach Anspruch 6, **dadurch gekennzeichnet,** daß einer der vier Widerstände (Rᵢ, Rᵢᵢ, Rᵢᵢᵢ, Rᵢᵥ) ein temperaturempfindliches Element (R_{T}) ist.

8. Temperaturkompensationsschaltung nach einem der Ansprüche 1 bis 3, **dadurch gekennzeichnet,** daß der Temperaturimpulsbreiten-Umwandlungsschaltungsabschnitt (X) folgendes aufweist:
- eine Integrierschaltung mit einem Operationsverstärker (A), einem zwischen den Ausgangsanschluß und den invertierenden Eingangsanschluß des Operationsverstärkers (A) eingefügten Kondensator (C), mit einer Spannungsteilereinrichtung mit einem ersten Widerstand (Rᵢ) und einem zweiten Widerstand (Rᵢᵢ), wobei der Operationsverstärker (A) die erste Bezugsspannung (V₁) über seinen mit dem ersten und dem zweiten Widerstand (Rᵢ, Rᵢᵢ) verbundenen nicht invertierenden Eingangsanschluß und über seinen mit der ersten Bezugsspannung (V₁) über eine Reihenschaltung eines Widerstandes (Rᵢᵢᵢ) und eines temperaturempfindlichen Elements (R_{T}) verbundenen invertierenden Eingangsanschluß erhält;
- eine Umschalteinrichtung (S), die mit der ersten und der zweiten Bezugsspannung (V₁, V₂) und dem invertierenden Eingangsanschluß über einen vierten Widerstand (Rᵢᵥ) verbunden ist; und
- einen Spannungsimpulsbreitenwandler (2), der mit dem Ausgangsanschluß des Operationsverstärkers (A) verbunden ist, wobei dessen Ausgangsanschluß mit einem Steuereingang der Umschalteinrichtung (S) verbunden ist.

## Revendications

1. Circuit de compensation de température comprenant:
- une partie (X) de circuit de conversion température-durée d'impulsion, adaptée pour générer un signal (Vₚ) de durée d'impulsion, par lequel un rapport (D(T)) d'utilisation, qui est un rapport de temps d'une durée (t₁) de période de signal fort à une période (t₀) de répétition d'impulsions, est modifié en réponse à une température détectée par un élément (R_{T}) sensible à la température, et
- au moins une partie (Y_{N}) de circuit de compensation de température, adaptée pour appliquer un traitement de compensation de température à un signal mesuré (V_{NI}) de tension dérivé d'une borne (I_{N}) d'entrée sur la base dudit rapport (D(T)) d'utilisation, et ensuite fournir le signal mesuré (V_{N0}) de tension compensé en température à une borne (O_{N}) de sortie, caractérisé en ce que:
- ladite partie (Y_{N}) de circuit de compensation de température comprend un moyen (C_{N}) de division de tension pour diviser le signal mesuré (V_{NI}) de tension, qui est fourni à travers ladite borne (I_{N}) d'entrée, en un signal fort (V_{NB}) de tension et un signal faible (V_{NS}) de tension et
- un moyen (D_{N}) de commutation pour sortir de façon alternative lesdits signaux fort et faible (V_{NB}, V_{NS}) de tension fournis à partir du moyen (C_{N}) de division de tension à ladite borne (O_{N}) de sortie en réponse à un changement FORT/FAIBLE du signal (Vₚ) de durée d'impulsion fourni à partir de ladite partie (X) de circuit de conversion température-durée d'impulsion.

2. Circuit de compensation de température selon la revendication 1, caractérisé en ce que ledit moyen (C_{N}) de division de tension est composé d'au moins deux résistances (R_{2N}, R_{3N}...) connectées en série, et en ce que l'une desdites au moins deux résistances (R_{2N}, R_{3N}...) est une résistance variable.

3. Circuit de compensation de température selon la revendication 2, caractérisé en ce que ledit moyen (C_{N}) de division de tension est composé de trois résistances (R_{1N}, R_{2N}, R_{3N},) connectées en série, pour lesquelles les branchements pour les tensions divisées sont disposés respectivement entre lesdites première et deuxième résistances (R_{1N}, R_{2N}) et entre lesdites deuxième et troisième résistances (R_{2N}, R_{3N}).

4. Circuit de compensation de température selon l'une des revendications 1 à 3, caractérisé en ce que la partie (X) du circuit de conversion température-durée d'impulsion est un circuit ouvert de commande en boucle.

5. Circuit de compensation de température selon l'une des revendications 1 à 3, caractérisé en ce que la partie (X) du circuit de conversion température-durée d'impulsion est un circuit fermé de commande en boucle.

6. Circuit de compensation de température selon l'une des revendications 1 à 3, caractérisé en ce que la partie (X) du circuit de conversion température-durée d'impulsion comprend :
- un circuit d'intégration avec un amplificateur opérationnel (A), un condensateur (C) inséré entre la borne de sortie et la borne d'entrée inverseuse dudit amplificateur opérationnel (A), avec un moyen de division de tension ayant une première résistance (Rᵢ) et une deuxième résistance (Rᵢᵢ), ledit amplificateur opérationnel (A) recevant la première tension (V₁) de référence par l'intermédiaire de sa borne d'entrée non inverseuse connectée avec lesdites première et deuxième résistances (Rᵢ, Rᵢᵢ), et par l'intermédiaire de sa borne d'entrée inverseuse connectée avec ladite première tension (V₁) de référence à travers une troisième résistance (Rᵢᵢᵢ),
- deux résistances (R₁, R₂) pour diviser ladite première tension (V₁) de référence et une seconde tension (V₂) de référence,
- un moyen (S) de commutation connecté avec lesdites deux résistances (R₁, R₂) et avec ladite borne d'entrée inverseuse à travers une quatrième résistance (Rᵢᵥ), et
- un convertisseur (2) de durée d'impulsion de tension couplé avec la borne de sortie dudit amplificateur opérationnel (A), dont la borne de sortie est connectée à une entrée de commande dudit moyen (S) de commutation.

7. Circuit de compensation de température selon la revendication G, caractérisé en ce que l' une desdites quatre résistances (Rᵢ, Rᵢᵢ, Rᵢᵢᵢ, Rᵢᵥ) est un élément (R_{T}) sensible à la température.

8. Circuit de compensation de température selon l'une des revendications 1 à 3, caractérisé en ce que la partie (X) du circuit de conversion température-durée d'impulsion comprend:
- un circuit d'intégration avec un amplificateur opérationnel (A), un condensateur (C) inséré entre la borne de sortie et la borne d'entrée inverseuse dudit amplificateur opérationnel (A), avec un moyen de division de tension ayant une première résistance (Rᵢ) et une deuxième résistance (Rᵢᵢ), ledit amplificateur opérationnel (A) recevant une première tension (V₁) de référence par l'intermédiaire de sa borne d'entrée non inverseuse connectée avec lesdites première et deuxième résistances (Rᵢ, Rᵢᵢ), et par l'intermédiaire de sa borne d'entrée inverseuse connectée avec ladite première tension (V₁) de référence à travers une troisième résistance (Rᵢᵢᵢ) et un élément (R_{T}) sensible à la température connectés en série,
- un moyen (S) de commutation connecté avec lesdites première et seconde tensions (V₁, V₂) de référence et avec ladite borne d'entrée inverseuse à travers une quatrième résistance (Rᵢᵥ), et
- un convertisseur (2) de durée d'impulsion de tension couplé avec la borne de sortie dudit amplificateur opérationnel (A), dont la borne de sortie est connectée à une entrée de commande dudit moyen (S) de commutation.
